# EUROPÄISCHE PATENTANMELDUNG

(11) **EP 4 016 591 A1**
(43) Veröffentlichungstag der Anmeldung: **22.06.2022**
(21) Anmeldenummer: 22155151.8
(22) Anmeldetag: 25.01.2021
(51) Int. Cl.: H01L 21/48, H01L 23/473, H01L 23/373, H01S 5/024

(54) **VERFAHREN ZUR HERSTELLUNG EINES KÜHLELEMENTS UND KÜHLELEMENT HERGESTELLT MIT EINEM SOLCHEN VERFAHREN**

(30) Priorität: 20.02.2020 DE 102020104493
(62) Teilanmeldung aus: 21702200.3
(71) Anmelder: Rogers Germany GmbH, 92676 Eschenbach (DE)
(72) Erfinder: Rupp, Thomas, 92715 Püchersreuth (DE); Lechner, Ralf, 95473 Creußen (DE)
(74) Vertreter: Müller Schupfner & Partner Patent- und Rechtsanwaltspartnerschaft mbB

(57) **Zusammenfassung**

Verfahren zur Herstellung eines Kühlelements (1), insbesondere eines Mikrokühlelements, umfassend:
- Bereitstellen mindestens einer ersten Metallschicht (11) und mindestens einer zweiten Metallschicht (12),
- Oxidieren (101) der mindestens einen ersten Metallschicht (11) und/oder der mindestens einen zweiten Metallschicht (12),
- Strukturieren (102) der mindestens einen ersten Metallschicht (11) und/oder der mindestens einen zweiten Metallschicht (12) zur Ausbildung mindestens einer Ausnehmung (21, 22),
- Verbinden (103) der mindestens einen ersten Metallschicht (11) und der mindestens einen zweiten Metallschicht (12) zur Ausbildung des Kühlelements (1) insbesondere durch Bonden, wobei im zusammengefügten Zustand durch die Ausnehmung (21, 22) in der mindestens einen ersten Metallschicht (11) und/oder der mindestens einen zweiten Metallschicht (12) zumindest ein Teilabschnitt eines Kühlkanals im Kühlelement (1) gebildet wird, und

wobei vor dem Verbinden (103) eine Innenseite der Ausnehmung (21, 22) zumindest abschnittsweise, vorzugsweise vollständig, befreit von einer oxidierten Oberfläche bereitgestellt wird.

## Beschreibung

Die vorliegende Erfindung betrifft ein Verfahren zur Herstellung eines Kühlelements und ein Kühlelement hergestellt mit einem solchen Verfahren.

Aus dem Stand der Technik sind Kühlelemente zum Kühlen von elektrischen bzw. elektronischen Bauteilen, insbesondere Halbleitern, wie z. B. Laserdioden, hinlänglich bekannt. Dabei entwickeln die elektrischen bzw. elektronischen Bauteile während ihres Betriebs Wärme, die mittels des Kühlelements abgeführt werden soll, um so wiederum eine dauerhafte Funktionalität der elektrischen bzw. elektronischen Bauteile zu gewährleisten. Dies trifft insbesondere für Laserdioden zu, bei denen bereits Temperaturunterschiede von wenigen °C zu signifikanten Beeinträchtigungen der Leistung und/oder Lebensdauer führen können.

Zum Kühlen der Bauteile weisen die Kühlelemente, die in der Regel an die Bauteile angebunden sind, typischerweise einen Kühlkanal auf, durch den im Betrieb ein Kühlfluid geleitet wird, um vom elektrischen bzw. elektronischen Bauteil ausgehende Wärme aufzunehmen und abzutransportieren. Vorzugsweise wird hierbei eine Finnenstruktur verwendet, bei der mehrere stegartige Elemente in den Kühlkanal hineinragen, um eine möglichst große Kontaktfläche zum Kühlfluid bereitzustellen, wodurch die Wärmeübertragung von Wandungen, die den Kühlkanal begrenzen, auf das Kühlfluid verbessert wird.

Entsprechend ist es erstrebenswert, möglichst viele dieser stegartigen Elemente auf möglichst kleinstem Raum zu vereinen, um für eine optimale Kühlleistung am Übergang zwischen Finnenstruktur und Fluid zu sorgen. Diese feinstrukturierte Gestalt der stegartigen Elemente macht deren Handhabung im Herstellungsverfahren schwierig.

Aus der DE 10 2004 002 841 B3 ist ein Verfahren zur Herstellen von Kühlelementen bekannt, bei dem ein Kühlelement hergestellt wird, in dem im Anschluss an eine Strukturierung ein Oxidieren der einzelnen Metallschichten vorgenommen wird. Die durch die Strukturierung realisierten Ausnehmungen bilden dann im gefertigten Kühlelement zumindest einen Teilabschnitt eines Kühlkanals, der durch ein Stapeln der Metallschichten und ein anschließendes Verbinden der gestapelten Metallschichten gebildet wird.

Hiervon ausgehend macht es sich die vorliegende Erfindung zur Aufgabe, das Herstellen der Kühlelemente und die Kühlelemente zu verbessern, insbesondere wenn vergleichsweise schmale Kühlkanäle im Kühlelement vorgesehen sind.

Diese Aufgabe wird gelöst durch ein Verfahren gemäß Anspruch 1 und ein Kühlelement gemäß Anspruchs 10. Weitere Vorteile und Eigenschaften der Erfindung ergeben sich aus den Unteransprüchen sowie der Beschreibung und den beigefügten Figuren.

Gemäß einem ersten Aspekt der vorliegenden Erfindung ist ein Verfahren zur Herstellung eines Kühlelements, insbesondere eines Mikrokühlelements, vorgesehen, umfassend:
- Bereitstellen mindestens einer ersten Metallschicht und mindestens einer zweiten Metallschicht,
- Oxidieren der mindestens einen ersten Metallschicht und/oder der mindestens einen zweiten Metallschicht,
- Strukturieren der mindestens einen ersten Metallschicht und/oder der mindestens einen zweiten Metallschicht zur Ausbildung mindestens einer Ausnehmung,
- Verbinden der mindestens einen ersten Metallschicht und der mindestens einen zweiten Metallschicht zur Ausbildung des Kühlelements, insbesondere durch ein Bonden, beispielsweise durch ein Erhitzen, wobei in einem zusammengefügten Zustand durch die Ausnehmung in der mindestens einen ersten Metallschicht und/oder der mindestens einen zweiten Metallschicht zumindest ein Teilabschnitt eines Kühlkanals im Kühlelement gebildet wird, wobei vor dem Verbinden eine Innenseite der Ausnehmung zumindest abschnittsweise, vorzugsweise vollständig, befreit von einer oxidierten Oberfläche bereitgestellt wird bzw. eine Innenseite der Ausnehmung befreit von einer oxidierten Oberfläche dem Verbinden oder einem Verbindungsprozess zur Verfügung gestellt wird.

Im Gegensatz zum Stand der Technik ist es vorgesehen, gezielt auf eine oxidierte Oberfläche an der Innenseite der Ausnehmungen zu verzichten, wodurch es in vorteilhafter Weise möglich ist, zu verhindern, dass im Anbindungsprozess bzw. beim Verbinden, bei dem die mindestens eine erste Metallschicht mit der mindestens einen zweiten Metallschicht verbunden wird, eine Schmelze gebildet wird, die in den Bereich der Ausnehmung bzw. den später gefertigten Kühlkanal gelangen könnte und so eine Ausdehnung des Kühlkanals im Bereich der Ausnehmung reduziert oder sogar zu einer Verstopfung des Kühlkanals in diesem Teilabschnitt des Kühlkanals führen kann. Dies hat insbesondere für Kühlelemente mit vergleichsweise dünnen bzw. schmalen Kühlkanälen, insbesondere bei Mikrokanalkühlern, einen entscheidenden Vorteil, da so in der Herstellung ein Risiko für ein Verstopfen der Kühlkanäle verhindert oder reduziert werden kann. Vorstellbar ist es dabei, dass eine oxidierte Oberfläche nach dem Oxidieren entfernt wird, beispielsweise durch einen im Anschluss an das Oxidieren durchgeführten weiteren Ätzschritt, insbesondere wenn das Strukturieren vor dem Oxidieren erfolgte. Es ist auch vorstellbar, dass die oxidierte Oberfläche mechanisch entfernt wird, beispielsweise durch ein Polieren oder einen spanenden Vorgang.

Vorzugsweise ist es vorgesehen, dass das Oxidieren zeitlich vor dem Strukturieren durchgeführt wird. Durch das Strukturieren, d. h. insbesondere das Ausbilden der mindestens einen Ausnehmung, zeitlich nach dem Oxidieren wird sichergestellt, dass die hergestellte Ausnehmung keine oxidierte Oberfläche an ihrer Innenseite aufweist, da die Innenseite keine Oxidation nach dem Strukturieren mehr erfährt und erst nach dem Oxidieren gebildet wird. Im Gegensatz zum Stand der Technik ist es insbesondere vorgesehen, dass das Oxidieren vor dem Strukturieren erfolgt, während es bei der Ausbildung von Kühlelementen im Stand der Technik üblich ist, zunächst das Strukturieren vorzunehmen und anschließend das Oxidieren, was erforderlich ist, um im Rahmen eines vorgesehenen Verbindungsverfahrens, insbesondere durch Bonden, die notwendige Voraussetzung für die gewünschte Verbindung zwischen der mindestens einen ersten und der mindestens einen zweiten Metallschicht zu schaffen. Durch das Abändern der Reihenfolge wird insbesondere verhindert, dass beispielsweise Ätzflanken der im Rahmen des Strukturierens gebildeten Ausnehmung durch ein anschließendes Oxidieren mit einer oxidierten Oberfläche versehen werden.

Durch das Abändern der zeitlichen Reihenfolge ist es außerdem in vorteilhafter Weise möglich, das Oxidieren nicht manuell durchführen zu müssen. Dies ist nämlich dann erforderlich, wenn das Strukturieren vor dem Oxidieren durchgeführt wird und zu feinstrukturierten Einzelbauteilen bzw. zu einer feinstrukturierten mindestens einen ersten Metallschicht und/oder mindestens einen zweiten Metallschicht führt, die im Rahmen einer automatisierten Handhabe Gefahr läuft, beschädigt zu werden. Dementsprechend ist es mit der geänderten Reihenfolge insbesondere möglich, eine Automatisierung, insbesondere für das Oxidieren der mindestens einen ersten Metallschicht und/oder mindestens einen zweiten Metallschicht, vorzunehmen. Es ist sogar vorstellbar, dass die mindestens eine erste Metallschicht und/oder die mindestens eine zweite Metallschicht während des Oxidierens bzw. unmittelbar vor oder nach dem Oxidieren mit einem Greifelement, insbesondere mit einem ein Unterdruck- bzw. ein Vakuum verwendenden Greifelement, gehandhabt werden. Außerdem lässt sich die Wahrscheinlichkeit für eine unzureichende Bindung durch ein fehlerhaftes Oxidieren zwischen der mindestens einen ersten Metallschicht und der mindestens einen zweiten Metallschicht reduzieren, wodurch die Anzahl der fehlerhaft gefertigten Kühlelemente reduziert wird.

Insbesondere handelt es sich bei dem Kühlelement um ein Mikrokanalkühlelement, das eine Anschlussfläche aufweist, an dem ein elektrisches Bauteil, insbesondere eine Laserdiode, montiert werden kann. Vorzugsweise ist es weiterhin vorgesehen, dass das Verfahren ferner ein Stapeln der mindestens einen ersten Metallschicht und der mindestens einen zweiten Metallschicht entlang einer Stapelrichtung unter Ausbildung des mindestens einen Teilabschnitts des Kühlfluidkanals umfasst. Insbesondere ist es vorgesehen, dass die mindestens eine erste Metallschicht und/oder die mindestens eine zweite Metallschicht sich entlang einer Haupterstreckungsebene erstrecken und entlang einer senkrecht zur Haupterstreckungsebene verlaufenden Stapelrichtung übereinandergestapelt werden. Die Ausnehmungen können dabei einen quadratischen, kreisförmigen, rechteckigen und/oder elliptischen Querschnitt aufweisen. Ferner ist es dabei vorgesehen, dass der gefertigte Kühlkanal Teilabschnitte aufweist, die parallel, schräg oder senkrecht zur Haupterstreckungsebene bzw. Stapelrichtung verlaufen. Beispielsweise ist die mindestens eine erste Metallschicht, die mindestens eine zweite Metallschicht und/oder die mindestens eine dritte Metallschicht aus Kupfer. Dabei können sich die mindestens eine erste Metallschicht, die mindestens eine zweite Metallschicht und/oder die mindestens eine dritte Metallschicht in Hinblick auf ihre Materialwahl einander entsprechen oder unterscheiden, beispielsweise in Bezug auf die Metallart, eine Menge an Fremdstoffen und/oder eine Ausgangskorngröße.

Vorzugsweise umfasst das Kühlelement mindestens eine dritte Metallschicht, die sich ebenfalls entlang einer Haupterstreckungsebene erstreckt und in einer senkrecht zur Stapelrichtung zusammen mit der mindestens einen ersten Metallschicht und der mindestens einen zweiten Metallschicht übereinandergestapelt angeordnet ist. Dabei ist es insbesondere vorgesehen, dass sich die mindestens eine erste Metallschicht, die mindestens eine zweite Metallschicht und die mindestens eine dritte Metallschicht hinsichtlich der Lage und Form ihrer Ausnehmungen voneinander unterscheiden. Insbesondere ist es vorgesehen, dass die übereinander angeordneten mindestens eine erste Metallschicht, mindestens eine zweite Metallschicht und/oder mindestens eine dritte Metallschicht im gestapelten Zustand den Kühlkanal ausbilden, durch welchen das Kühlfluid während des Betriebs leitbar ist, um die Wärme von der Anschlussfläche wegzuführen.

Ferner weist der Kühlkanal insbesondere einen Zuleitungsbereich und einen Ableitbereich auf, die sich beispielsweise durch die mindestens eine erste Metallschicht, die mindestens eine zweite Metallschicht und/oder die mindestens eine dritte Metallschicht hindurcherstrecken, wobei der Kühlkanal vorzugsweise derart ausgebildet ist, dass bei der Überführung des Kühlfluides von dem Zuleitungsbereich in den Ableitbereich das Kühlfluid den Teil der Ausnehmung, der durch das Strukturieren erstellt worden ist, passieren muss. Vorzugsweise passiert das Kühlfluid die Finnenstruktur beim Übergang vom Zuleitungsbereich zum Ableitbereich. Insbesondere ist es vorgesehen, dass das Kühlfluid entlang der Stapelrichtung den Kühlkanal durchsetzt, insbesondere die Finnenstruktur entlang der Stapelrichtung passiert.

Weiterhin ist der Kühlkanal derart ausgelegt, dass das durch den Kühlkanal geleitete Fluid von der mindestens einen ersten Metallschicht über die zumindest eine zweite Metallschicht bis in die mindestens eine dritten Metallschicht geleitet wird, woraufhin das Fluid in der mindestens einen dritten Metallschicht umgelenkt wird und wieder in die mindestens eine zweite Metallschicht und/oder mindestens eine erste Metallschicht zurückgeführt wird. Hier hat das Kühlfluid wieder Zugang zum Ableitbereich des Kühlkanals und lässt sich entsprechend aus dem Kühlkanal ableiten. Alternativ ist es vorstellbar, dass die erste Metallschicht und/oder die zweite Metallschicht eine Finnenstruktur bilden, bei der Finnen in einen Fluidkanal hineinragen, an dem das Kühlfluid entlang einer einzigen Strömungsrichtung vorbeigeführt wird. Grundsätzlich sind verschiedenste Gestaltungen von Kühlkanälen vorstellbar, bei denen die stegartigen Elemente mittels Erodieren, Laser und/oder Ätzen hergestellt werden.

Weiterhin ist es vorzugsweise vorgesehen, dass die mindestens eine erste Metallschicht mit der mindestens einen zweiten Metallschicht vorzugsweise durch Bonden stoffschlüssig verbunden wird. Insbesondere ist es vorgesehen, dass die mindestens eine erste Metallschicht mit der mindestens einen zweiten Metallschicht, besonders bevorzugt mit der mindestens einen dritten Metallschicht oder weiteren Metallschichten, ohne die Verwendung eines Haftvermittlers oder eines klassischen metallischen Lötmaterials miteinander verbunden wird. Beispielsweise werden sie durch ein entsprechendes Erhitzen und ggf. unter Druck derart miteinander verbunden, dass sich ein monolithischer Grundkörper für das Kühlelement ausbildet.

Vorzugsweise ist es vorgesehen, dass zum Strukturieren die mindestens eine erste Metallschicht und/oder die mindestens eine zweite Metallschicht geätzt, gelasert und/oder laserunterstützt. Erfindungsgemäß wird die erste Metallschicht und/oder zweite Metallschicht erodiert. Insbesondere durch das Erodieren lassen sich besonders feine Strukturierungen und Ausnehmungen in der mindestens einen ersten Metallschicht, in der mindestens einen zweiten Metallschicht und/oder in der mindestens einen dritten Metallschicht realisieren. Hier erweist sich die Reihenfolge, bei der das Oxidieren zeitlich vor dem Strukturieren erfolgt, als vorteilhaft, weil dadurch auf ein nachgeschaltetes Oxidieren, insbesondere manuelles Oxidieren, verzichtet werden kann. Das Strukturieren mittels Ätzen erweist sich insbesondere deswegen als vorteilhaft, weil es einfach, schnell und prozesssicher zu einer Strukturierung führt. Darüber hinaus wird dann im Falle eines dem Strukturieren vorangehenden Oxidierens gerade verhindert, dass sich Ätzflanken ausbilden, die mit einer oxidierten Oberfläche nach einem Oxidieren beschichtet wären.

Insbesondere ist es vorgesehen, dass vor dem Verbinden ein an die Ausnehmung angrenzender Bereich einer Oberseite und/oder einer Unterseite der mindestens einen ersten Metallschicht und/oder der mindestens einen zweiten Metallschicht befreit von einer oxidierten Oberfläche bereitgestellt wird. Beispielsweise wird hierbei ein Teil der oxidierten Oberfläche an der Oberseite und/oder an der Unterseite der mindestens einen ersten Metallschicht und/oder der mindestens einen zweiten Metallschicht weggeätzt oder mechanisch, durch einen Polieren, wieder entfernt. Dadurch bildet dieser an die Ausnehmung angrenzende Bereich beim Verbinden keine Schmelze aus, die gegebenenfalls in die Ausnehmungen gelangen könnte, und den später gefertigten Kühlkanal verstopfen könnte. Beispielsweise verläuft oder bemisst sich der an die Ausnehmungen angrenzende Bereich an der Oberseite und/oder Unterseite in eine parallel zur Haupterstreckungsebene verlaufende Richtung bis zu 3 mm, bevorzugt bis zu 2 mm und besonders bevorzugt bis zu 1 mm vom Rand der Ausnehmung.

Vorzugsweise ist es vorgesehen, dass zusätzlich zu der Ausnehmung oder Aussparung in der mindestens einen ersten Metallschicht und/oder der mindestens einen zweiten Metallschicht ein Bereich reduzierter Dicke realisiert wird. In dem Bereich mit der reduzierten Dicke kann ein weiterer, im Wesentlichen parallel zur Haupterstreckungsebene verlaufender Teilabschnitt des Kühlkanals gebildet werden, da dieser Bereich ebenfalls beim Verbinden keine Schmelze bildet, die eine Anbindung zwischen der mindestens einen ersten Metallschicht und/oder der mindestens einen zweiten Metallschicht ermöglicht. Nach dem Verbinden der mindestens einen ersten Metallschicht und der mindestens einen zweiten Metallschicht wird im Bereich mit der reduzierten Dicke ein einsprechender Hohlbereich zwischen der mindestens einen ersten Metallschicht und der mindestens einen zweiten Metallschicht ausgebildet. Beispielsweise wird im geplanten Bereich mit der reduzierten Dicke die mindestens eine erste Metallschicht bzw. die mindestens eine zweite Metallschicht nur von einer Seite, d. h. nur an einer Oberseite oder einer Unterseite, angeätzt bzw. geätzt, während zur Ausbildung der Ausnehmung die mindestens eine erste Metallschicht und/oder die mindestens eine zweite Metallschicht beidseitig, d. h. an Oberseite und Unterseite, angeätzt bzw. geätzt werden. Mit anderen Worten: die Maskierungen für die Oberseite und die Unterseite stimmen in den Bereichen zur Ausbildung der Ausnehmung überein, während im Bereich der geplanten reduzierten Dicke eine der ober- bzw. unterseitigen Maskierungen geschlossen ist. Ferner ist auch vorstellbar, dass der Bereich mit reduzierter Dicke von der Ausnehmung beabstandet ist, um beispielsweise einen im Wesentlichen parallel zur Haupterstreckungsebene verlaufenden Teilabschnitt des Kühlkanals zu bilden, dessen senkrecht zur Haupterstreckungsebene verlaufenden Ausdehnung durch den Betrag festgelegt wird, um den der Bereich mit der reduzierten Dicke gegenüber der Dicke der mindestens einen ersten Metallschicht, der mindestens einen zweiten Metallschicht und/oder der mindestens einen dritten Metallschicht reduziert ist.

Beispielsweise nimmt ein Verhältnis der reduzierten Dicke zur Dicke der mindestens einen ersten bzw. zweiten Metallschicht einen Wert zwischen 0,25 und 0,8, bevorzugt zwischen 0,3 und 0,7 und besonders bevorzugt zwischen 0,4 und 0,6 an.

Weiterhin ist es bevorzugt vorgesehen, dass das Oxidieren thermisch und/oder chemisch, insbesondere nasschemisch,durchgeführt wird. Bevorzugt erfolgt das Oxidieren thermisch, da dies vorteilhaft ist für das anschließende Laminieren und dies erleichtert. Beispielsweise wird hierzu die mindestens eine erste Metallschicht und/oder die mindestens eine zweite Metallschicht durch eine entsprechende Anlage, insbesondere horizontal, befördert. Hier erweist sich die Vorgehensweise, bei der das Oxidieren vor dem Strukturieren erfolgt, als besonders vorteilhaft, weil dies eine vereinfachte Handhabe beim Oxidieren gestattet, wodurch der Fertigungsprozess des Kühlelements vereinfacht wird. Das Oxidieren kann vorzugsweise einseitige oder beidseitig erfolgen.

Vorzugsweise weist das gefertigte Kühlelement eine obere Deckschicht und/oder eine untere Deckschicht auf, wobei in Stapelrichtung gesehen unter der oberen Deckschicht und/oder über der unteren Deckschicht die mindestens eine erste Metallschicht und/oder die mindestens eine zweite Metallschicht und/oder mindestens eine dritte Metallschicht angeordnet ist, wobei die obere Deckschicht und/oder die untere Deckschicht einen Anschlussbereich zur Anbindung eines zu kühlenden Bauteils, insbesondere einer Laserdiode, aufweist. Dabei ist es beispielsweise vorstellbar, dass die obere und/oder untere Deckschicht aus einer Keramik oder einem Keramikelement gefertigt ist. Dies erweist sich insbesondere als vorteilhaft für solche Anwendungsfälle, in denen eine elektrische Isolation zum Kühlelement erforderlich ist. Hierzu wird bevorzugt ein Direktanbindungsverfahren, wie ein DCB-Verfahren, oder ein Aktivlötverfahren verwendet.

Vorzugsweise ist es vorgesehen, dass die Ausnehmung in einer parallel zu einer Haupterstreckungsebene verlaufenden Richtung eine Ausdehnung, insbesondere eine Breite, bis zu 0,8 mm, bevorzugt bis zu 0,5 mm und besonders bevorzugt bis zu 0,4 mm aufweist. Für solche vergleichsweise schmalen Ausdehnungen erweist sich die beschriebene Vorgehensweise besonders vorteilhaft, da bei den entsprechenden Ausdehnungen, insbesondere bei denen bis zu 0,4 mm, ein erhöhtes Risiko einer möglichen Verstopfung durch die Schmelze, ausgebildet beim Verbinden, existiert. Durch die beschriebene Vorgehensweise wird dennoch die Wahrscheinlichkeit reduziert, dass die Schmelze in die Ausnehmung gelangen kann und den späteren Teilabschnitt des Kühlkanals im gefertigten Zustand des Kühlelements verstopfen könnte. Unter der Breite versteht der Fachmann, insbesondere bei rechteckigen Ausnehmungen, bevorzugt die Richtung, die senkrecht zur Längsrichtung der Ausnehmung verläuft und bevorzugt die schmalere Seite der Ausnehmung bildet.

In einer weiteren Ausführungsform ist es vorgesehen, dass ein Bonden, insbesondere Erhitzen, zum Verbinden der mindestens einen ersten Metallschicht mit der mindestens einen zweiten Metallschicht bei einer Temperatur zwischen 500 °C und 1080 °C, insbesondere zwischen 850 °C und zwischen 1080 °C oder 500 °C und 660 °C, durchgeführt wird. Durch die angegebenen Temperaturen beim Bonden wird eine Schmelze in den Bereichen mit oxidierter Oberfläche ausgebildet, die zum Verbinden der mindestens einen ersten Metallschicht und/oder der mindestens einen zweiten Metallschicht führt unter Ausbildung eines monolithischen bzw. einstückigen Kühlelements. Insbesondere entspricht das Verbinden einem Direktmetallanbindungsverfahren, beispielsweise einem DCB oder DAB-Verfahren.

Gemäß einer bevorzugten Ausführungsform der vorliegenden Erfindung ist es vorgesehen, dass die mindestens eine erste Metallschicht eine in Stapelrichtung bemessende Dicke von zwischen 100 µm und 1mm, bevorzugt zwischen 150 µm und 550 µm und besondere bevorzugt zwischen 150 µm und 350 µm aufweist. Dabei erstreckt sich die mindestens eine erste Metallschicht und/oder die mindestens eine zweite Metallschicht entlang einer Haupterstreckungsebene und ist beispielsweise aus Kupfer. Es ist auch vorstellbar, dass sich die mindestens eine erste Metallschicht von der mindestens einen zweiten Metallschicht unterscheidet, beispielsweise in Hinblick auf Ausgangskorngröße, Anteil an Fremdstoffen oder Material, z. B. eine Schicht aus Kupfer und eine weitere Schicht aus einer Kupferlegierung.

Ein weiterer Gegenstand der vorliegenden Erfindung ist ein Kühlelement hergestellt mit einem erfindungsgemäßen Verfahren. Alle für das Verfahren beschriebenen Eigenschaften und Vorteile lassen sich analog auf das Kühlelement übertragen und andersrum.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigt:
- **Fig. 1:**: schematische Explosionsdarstellung eines Kühlelements gemäß einer ersten beispielhaften Ausführungsform der vorliegenden Erfindung,
- **Fig. 2**: schematische Darstellung einer ersten Metallschicht für ein Kühlelement aus Figur 1,
- **Fig.3:**: schematische Darstellung eines Kühlelements gemäß einer zweiten beispielhaften Ausführungsform der vorliegenden Erfindung ,
- **Fig.4**: schematische Darstellung eines Verfahrens zur Herstellung eines Kühlelements gemäß einer beispielhaften Ausführungsform der vorliegende Erfindung und
- **Fig. 5a bis 5d**: schematische Darstellungen einer ersten Metallschicht und/oder einer zweiten Metallschicht für ein Kühlelement gemäß einer dritten, vierten, fünften und sechsten Ausführungsform der vorliegende Erfindung.

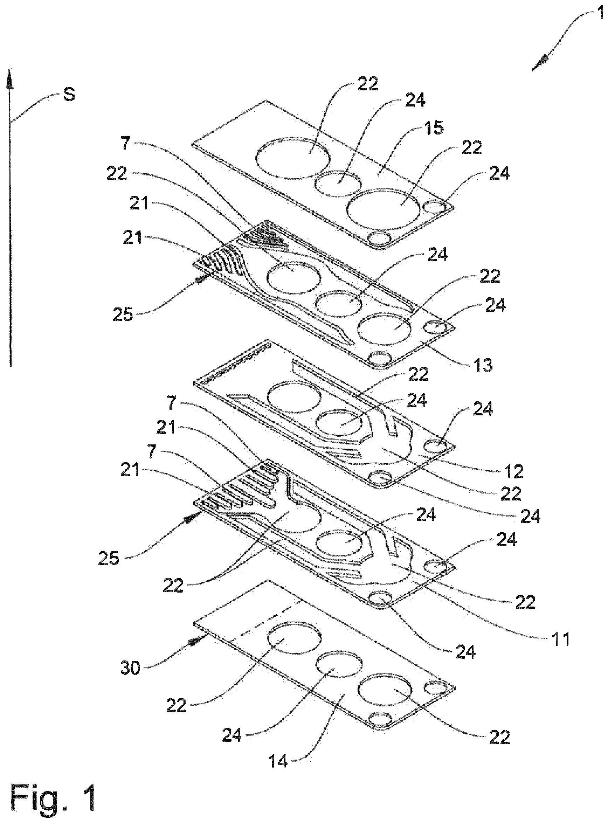

In **Figur 1** ist schematisch eine Explosionsdarstellung eines Kühlelements 1 gemäß einer ersten bevorzugten Ausführungsform der vorliegenden Erfindung dargestellt. Insbesondere handelt es sich bei dem Kühlelement 1 um ein solches, das zum Kühlen eines elektronischen oder elektrischen Bauteils (nicht dargestellt), insbesondere eines Halbleiterelements und besonders bevorzugt einer Laserdiode, vorgesehen ist. Zum Kühlen des elektrischen bzw. des elektronischen Bauteils bildet das gefertigte Kühlelement 1 einen Kühlkanal aus, durch den im Betrieb ein Kühlfluid leitbar ist, so dass das Kühlfluid Wärme, die von dem elektronischen bzw. elektrischen Bauteil im Betrieb ausgeht, aufnehmen und wegführen kann.

Hierzu sind in dem Kühlelement 1, insbesondere im Kühlkanal, vorzugsweise ein Zuleitungsbereich und ein Ableitungsbereich vorgesehen (nicht gezeigt), wobei über den Zuleitungsbereich das Kühlfluid eingeleitet wird und über den Ableitungsbereich wieder ausgeleitet wird. Vorzugsweise ist es vorgesehen, dass der Kühlkanal derart ausgestaltet ist, dass das Kühlfluid 1 beim Übergang vom Zuleitungsbereich zum Ableitungsbereich eine Finnenstruktur 25 passiert, die insbesondere in den Kühlkanal hineinragt bzw. diesen bildet. Bei der Finnenstruktur 25 handelt es sich vorzugsweise um stegartige Elemente 7 die in den Kühlkanal hineinragen, um eine möglichst große Kontaktfläche für das Fluid bereitzustellen, sodass eine wirkungsvolle Übertragung der Wärme vom stegartigem Element 7 bzw. der Wandung des Kühlkanals auf das Fluid möglich ist.

Vorzugsweise umfasst das Kühlelement 1 mindestens eine erste Metallschicht 11, mindestens eine zweite Metallschicht 12 und/oder mindestens eine dritte Metallschicht 13. Zur Ausbildung des Kühlkanals sind die mindestens eine erste Metallschicht 11, die mindestens zweite Metallschicht 12 und/oder die mindestens dritte Metallschicht 13 durch mindestens eine Ausnehmung 21, 22 derart strukturiert, dass sie durch ein Aufeinanderstapeln bzw. ein übereinanderlegen entlang der Stapelrichtung S den Kühlkanal ausbilden.

Dabei ist es insbesondere vorgesehen, dass die mindestens eine erste Metallschicht 11, die mindestens eine zweite Metallschicht 12 und/oder die mindestens eine dritte Metallschicht 13 jeweils anders strukturiert sind bzw. mit anders verlaufenden Ausnehmungen 21, 22 ausgestattet sind. Insbesondere ist es vorgesehen, dass die mindestens eine erste Metallschicht 11, die mindestens eine zweite Metallschicht 12 und/oder die mindestens eine dritte Metallschicht 13 mindestens einen ersten Teil 21 in der mindestens einen Ausnehmung 21, 22 ausformt, der die stegartigen Elemente 7 aufweist, die insbesondere sich in einer senkrecht zur Stapelrichtung S verlaufenden Haupterstreckungsebene HSE erstrecken. Neben dem ersten Teil 21 der mindestens einen Ausnehmung 21, 22 in der mindestens einen ersten Metallschicht 11 ist es vorzugsweise vorgesehen, dass ein zweiter Teil 22 der mindestens einen Ausnehmung 21, 22 in der mindestens einen ersten Metallschicht 11 für das Zuleiten oder Ableiten des Kühlfluides in den ersten Teil 21 bzw. aus dem ersten Teil 21 vorgesehen ist bzw. einen Teil des Zuleitungsbereich und/oder Ableitungsbereichs bildet.

Das Kühlelement 1 wird vorzugsweise in Stapelrichtung S durch eine obere Deckschicht 15 und eine untere Deckschicht 14 begrenzt, wobei die erste mindestens eine erste Metallschicht 11, die mindestens eine zweite Metallschicht 12 und/oder die mindestens eine dritte Metallschicht 13 in Stapelrichtung S gesehen zwischen der unteren Deckschicht 14 und der oberen Deckschicht 15 angeordnet ist. Insbesondere ist die Formation aus der mindestens einen ersten Metallschicht 11, der mindestens einen zweiten Metallschicht 12 und/oder der mindestens einen dritten Metallschicht 13 sandwichartig zwischen der oberen Deckschicht 15 und der unteren Deckschicht 14 angeordnet. Neben der mindestens einen Ausnehmung 21, 22, die sich zusammensetzt aus dem ersten Teil 21 und dem zweiten Teil 22, ist es vorzugsweise vorgesehen, dass das Kühlelement 1 bzw. die mindestens eine erste Metallschicht 11 eine weitere Ausnehmung 24 aufweist, die kein Bestandteil des Kühlkanals mit der Finnenstruktur 25 ist. Weiterhin ist es vorzugsweise vorgesehen, dass an der oberen Deckschicht 15 und/oder der unteren Deckschicht 14 eine Anschlussfläche 30 vorgesehen ist. Insbesondere wird an dieser Anschlussfläche 30 das elektrische bzw. elektronische Bauteil angebunden, insbesondere in Stapelrichtung S gesehen, oberhalb bzw. unterhalb der Finnenstruktur 25, die sich vorzugsweise in einer senkrecht zur Stapelrichtung S verlaufenden Richtung erstreckt. Mit anderen Worten: die Finnenstruktur 25, insbesondere deren stegartigen Elemente 7, erstreckt sich unterhalb der Anschlussfläche 30 und vorzugsweise parallel dazu. Durch die entsprechende Anordnung der Finnenstruktur 25 aus den stegartigen Elementen 7 oberhalb bzw. unterhalb der Anschlussfläche 30 lässt sich das elektrische bzw. das elektronische Bauteil wirkungsvoll mittels der Finnenstruktur 25 kühlen.

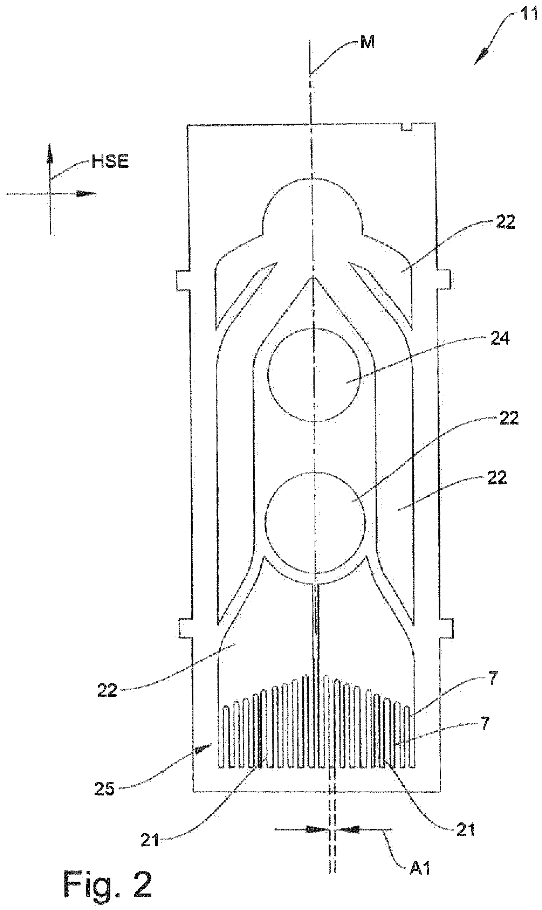

In **Figur 2** ist eine schematische Darstellung einer mindestens einen ersten Metallschicht 11 dargestellt, die beispielsweise in Figur 1 verbaut ist. In der dargestellten Ausführungsform ist die Finnenstruktur 25 aus stegartigen Elementen 7 ausgebildet, die sich in Haupterstreckungsebene HSE gesehen, unterschiedlich weit erstrecken. Insbesondere nimmt eine Länge der stegartigen Elemente 7 zu einer Mittelachse M der mindestens einen ersten Metallschicht 11 zu. Dadurch ist es in vorteilhafter Weise möglich, die Kühlwirkung insbesondere im Zentralbereich der Anschlussfläche 30 möglichst zu maximieren. Ferner ist es vorstellbar, dass die stegartigen Elemente parallel und/oder schräg zur Mittelachse M verlaufen. Vorzugsweise wird die Form der stegartigen Elemente 7 insbesondere deren Länge und/oder Neigung gegenüber der Mittelachse M entlang der Haupterstreckungsebene HSE durch das entsprechende Anforderungsprofil für das Kühlen des entsprechenden elektrischen oder elektronischen Bauteils bestimmt bzw. festgelegt.

Um einen möglichst geringen Abstand A1 zwischen zwei benachbarten stegartigen Elementen 7 zu erzielen, ist es vorzugsweise vorgesehen, dass der erste Teil 21 der mindestens einen Ausnehmung 21, 22 in der mindestens einen ersten Metallschicht 11 durch ein Erodieren, insbesondere Funkenerodieren, und/oder ein Ätzen erfolgt. Insbesondere handelt es sich dabei um ein Herstellen mittels Drahterodieren.

Ferner ist es vorgesehen, dass ein zweiter Teil 22 der mindestens einen Ausnehmung 21, 22 durch ein Ätzen erfolgt. Vorzugsweise wird das Ätzen insbesondere in großflächigen Bereichen des zweiten Teils 22 der Ausnehmung 21, 22 durchgeführt, d. h. in den späteren Zuführ- und/der Ableitbereichen, die für das Zuführen und das Ableiten des Kühlfluids ausgebildet sind. Im Gegensatz dazu ist es insbesondere vorgesehen, dass das Erodieren für die feinstrukturierte Ausformung der Ausnehmung 21, 22, d. h. den ersten Teil 21 der Ausnehmung 21, 22 vorgesehen ist. Es hat sich herausgestellt, dass dadurch vergleichsweise sehr geringe Abstände zwischen den stegartigen Elementen 7 hergestellt werden können, ohne dass man auf mehrere erste Metallschichten 11 mit geätzten ersten Teilen 21 der mindestens einen Ausnehmung 21, 22 angewiesen wäre, die übereinander gestapelt werden müssten, um einen möglichst geringen Abstand zwischen zwei stegartigen Elementen 7 zu realisieren. Vorzugsweise ist der Abstand A1 zwischen gegenüberliegenden Seitenwänden zwischen zwei stegartigen Elementen 7 kleiner als 0,4 mm, bevorzugt kleiner als 0,3 mm und besonders bevorzugt kleiner als 0,2 mm. Dadurch lassen sich möglichst viele stegartige Elemente 7 in die Finnenstruktur 25 integrieren. Entsprechend ist es möglich, die Kühlwirkung zu erhöhen, da die Kontaktfläche zwischen Kühlfluid und Wandlung des Kühlkanals in entsprechender Weise erhöht werden kann.

Vorzugsweise weist die mindestens eine erste Metallschicht 11, die mindestens eine zweite Metallschicht 12, die mindestens eine dritte Metallschicht 13, die obere Deckschicht 15 und/oder die untere Deckschicht 14 eine in Stapelrichtung S gemessene Dicke zwischen 0,2 und 0,7 mm, bevorzugt zwischen 0,35 und 0,6 mm und besonders bevorzugt zwischen 0,3 und 0,4 mm auf. Vorzugsweise bilden die mindestens eine erste Metallschicht 11, die mindestens eine zweite Metallschicht 12 und/oder die mindestens eine dritte Metallschicht 13 jeweils dieselbe Dicke aus. Weiterhin ist es bevorzugt vorgesehen, dass die mindestens eine erste Metallschicht 11, die mindestens eine zweite Metallschicht 12 und/oder die mindestens eine dritte Metallschicht 13 im Rahmen eines Sinterverfahrens zu einem integralen Kühlkanal geformt werden, indem durch eine entsprechende Temperaturbehandlung die Gefüge der mindestens einen ersten Metallschicht 11, der mindestens einen zweiten Metallschicht 12 und/oder der mindestens einen dritten Metallschicht 13 ineinander übergehen bzw. miteinander verschmelzen. Weiterhin ist es vorgesehen, dass auch die obere Deckschicht 15 und/oder die untere Deckschicht 14 jeweils mindestens eine Ausnehmung 21, 22 und/oder eine weitere Ausnehmung 24 aufweisen, wobei die obere Deckschicht 15 und/oder die untere Deckschicht 14 vorzugsweise frei sind von stegartigen Elementen 7 bzw. Bestandteilen einer späteren Finnenstruktur 25. Die weiteren Ausnehmungen 24 dienen vorzugsweise der Befestigung oder Fixierung des Kühlelements 1.

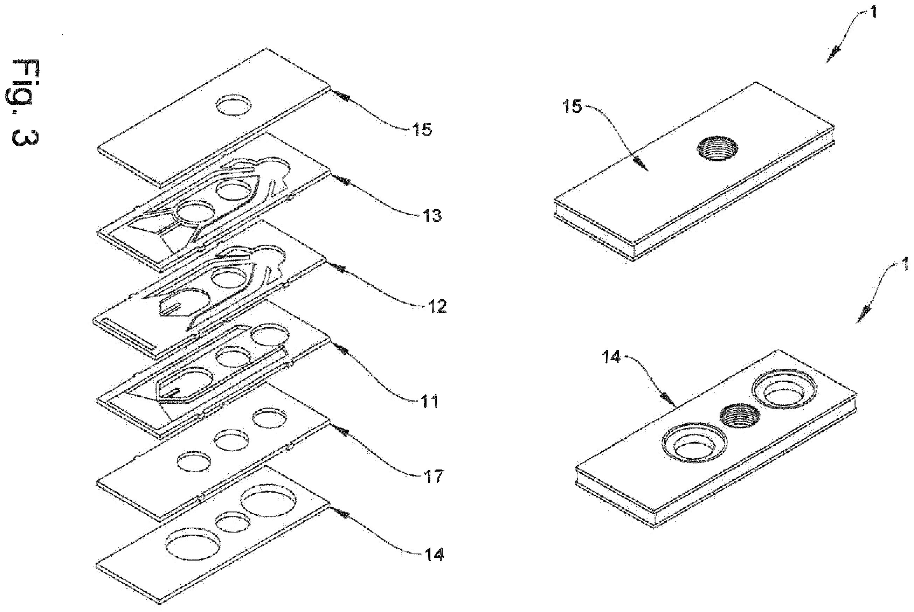

In **Figur 3** ist ein Kühlelement 1 gemäß einer zweiten bevorzugten Ausführungsform vorgesehen. Dabei entspricht das Kühlelement 1 im Wesentlichen demjenigen Kühlelement 1 aus der Figur 1 und unterscheidet sich im Wesentlichen nur dahingehend, dass die untere Deckschicht 14 und/oder die obere Deckschicht 15 als Metall-Keramik-Verbund ausgebildet ist. Insbesondere ist es dabei vorgesehen, dass die obere Deckschicht 15 und/oder die untere Deckschicht 14 jeweils eine Keramikschicht aufweisen, vorzugsweise aus Aluminiumnitrid, die beispielsweise beidseitig mit einer Metallschicht, vorzugsweise einer Kupferschicht, bedeckt ist. Beispielsweise handelt es sich um eine Keramikschicht aus Aluminiumnitrid, deren Dicke in Stapelrichtung S bemessen einen Wert von 0,1 mm bis 0,5 mm, vorzugsweise 0,2 mm bis 0,4 mm und besonders bevorzugt von im Wesentlichen 0,38 mm annimmt, während die außenliegenden Metallschichten, die die Keramikschicht jeweils bedecken, eine Dicke zwischen 0,05 und 0,4 mm, bevorzugt zwischen 0,1 und 0,3 mm und besonders bevorzugt zwischen 0,15 und 0,25 mm aufweisen.

Dabei ist es insbesondere vorgesehen, dass die Metallschichten, die an gegenüberliegenden Seiten der Keramikschicht ausgebildet sind, unterschiedlich dick sind. Beispielsweise weist die eine Metallschicht eine Kupferdicke von 0,2 mm auf, während die gegenüberliegende Kupferschicht eine Dicke von 0,12 mm aufweist, die insbesondere durch ein Diamantschleifen nach dem Anbindungsprozess der Metallschicht an die Kupferschicht realisiert ist. Vorzugsweise handelt es sich bei der oberen Deckschicht 15 und/oder der unteren Deckschicht 14 um ein Metall-Keramik-Verbund, der mittels eines DCB-Verfahrens hergestellt wurde.

Weiterhin ist es bevorzugt vorgesehen, dass das Kühlelement 1 aus Figur 3 eine Dichtelementträgerschicht 17 aufweist, in der bzw. mit der beispielsweise O-Ringe fixiert werden können, um eine entsprechende Abdichtung im Anschlussbereich für den Zuführ- und den Ableitbereich des Kühlelements 1 zu gewährleisten. Vorzugsweise handelt es sich bei der Dichtelementträgerschicht 17 um eine Metallschicht mit entsprechenden Ausnehmungen 21, 22 bzw. weiteren Ausnehmungen 24, wobei die Dichtelementträgerschicht 17 eine in Stapelrichtung bemessene Dicke zwischen 0,1 und 0,4 mm, bevorzugt zwischen 0,1 und 0,4 mm und besonders bevorzugt zwischen 0,2 und 0,3 mm aufweisen kann.

Darüber hinaus unterscheidet sich die Ausführungsform aus Figur 3 von derjenigen aus der Figur 1 dahingehend, dass das Kühlelement 1 an seiner oberen Deckschicht 15 geschlossen ist und eine Eingangsöffnung für das Zuführen des Kühlfluides und eine Ausgangsöffnung zum Abführen des Kühlfluides ausschließlich an der unteren Deckschicht 14 ausgebildet sind, sodass das Kühlfluid das über die untere Deckschicht 14 in das Kühlelement 1 eingeleitet wird, diese entlang der Stapelrichtung S durchsetzt und in der mindestens einen dritten Metallschicht 13 umgelenkt wird, um dann in entgegengesetzter Richtung das Kühlelement 1 wieder zu verlassen. Die obere Deckschicht 15 und die untere Deckschicht 14 aus einem Metall-Keramik-Verbund erweist sich insbesondere vorteilhaft für solche Anwendungsfälle, in denen das Kühlelement 1 elektrisch isoliert werden muss, von dem Bauelement, welches auf dem Kühlelement 1 bzw. an das Kühlelement 1 angebunden ist.

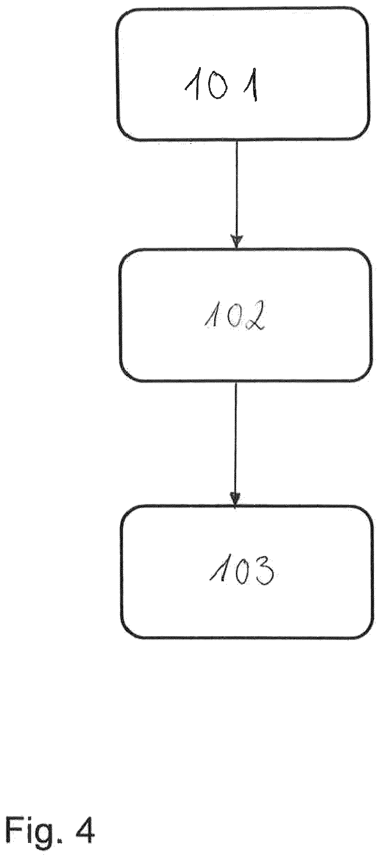

In **Figur 4** ist eine schematische Darstellung eines Verfahrens zur Herstellung eines Kühlelements 1 gemäß einer beispielhaften Ausführungsform der vorliegenden Erfindung gezeigt. Insbesondere ist es hier vorgesehen, dass in einem Vorbereitungsschritt die mindestens eine erste Metallschicht 11, die mindestens eine zweite Metallschicht 12 und/oder die mindestens eine dritte Metallschicht 13 bereitgestellt werden. Insbesondere werden die mindestens eine erste Metallschicht 11, die mindestens eine zweite Metallschicht 12 und/oder die mindestens eine dritte Metallschicht 13 als plattenförmige und/oder unstrukturierte Metallbleche bzw. Folien bereitgestellt.

Die bereitgestellte mindestens eine erste Metallschicht 11, die mindestens eine zweite Metallschicht 12 und/oder die mindestens eine dritte Metallschicht 13 wird vorzugsweise zunächst oxidiert, insbesondere indem sie durch eine entsprechende Anlage bzw. chemische Nasszelle, vorzugsweise horizontal, befördert wird oder werden. Durch dieses Oxidieren 101 wird die unstrukturierte mindestens eine erste Metallschicht 11, die mindestens eine zweite Metallschicht 12 und/oder die mindestens eine dritte Metallschicht 13 mit einer oxidierten Oberfläche versehen bzw. ausgestattet, insbesondere über die gesamte Außenseite der mindestens einen ersten Metallschicht 11, der mindestens einen zweiten Metallschicht 12 und/oder der mindestens einen dritten Metallschicht 13.

Anschließend wird die mindestens eine erste Metallschicht 11, die mindestens eine zweite Metallschicht 12 und/oder die mindestens eine dritte Metallschicht 13 strukturiert, beispielsweise indem sie geätzt und/oder erodiert wird bzw. werden, zur Ausbildung einer Ausnehmung 21, 22 und/oder einer weiteren Ausnehmung 24. Durch die Festlegung der Reihenfolge derart, dass ein Strukturieren 102 erst nach dem Oxidieren 101 erfolgt, ist es in vorteilhafter Weise möglich, Ätzflanken an den Innenseiten der Ausnehmungen 21, 22 in der mindestens einen ersten Metallschicht 11, der mindestens einen zweiten Metallschicht 12 und/oder der mindestens einen dritten Metallschicht 13 zu realisieren, die frei sind von einer oxidierten Oberfläche. Dies erweist sich als vorteilhaft, weil dadurch vermieden werden kann, dass beim späteren Verbinden 103 der mindestens einen ersten Metallschicht 11 mit der mindestens einen zweiten Metallschicht 12 eine beim Bindungsprozess entstehende Schmelze nicht die Ausdehnung der Ausnehmung 21, 22 reduziert oder hier sogar zu einer Verstopfung führt. Dies hat insbesondere einen positiven Effekt für solche Kühlelemente 1, deren Kühlkanäle vergleichsweise schmal bzw. dünn sind.

Nach dem Strukturieren 102 werden die mindestens eine erste Metallschicht 11 und die mindestens eine zweite Metallschicht 12 entlang einer Stapelrichtung S übereinander gestapelt und anschließend in einem Verbindungsprozess miteinander verbunden. Vorzugsweise wird hierzu das Ensemble aus der mindestens einen ersten Metallschicht 11 und der mindestens einen zweiten Metallschicht 12 auf eine Temperatur zwischen 850 °C und 1080 °C erhitzt, wodurch eine Verbindung der mindestens einen ersten Metallschicht 11 und der mindestens einen zweiten Metallschicht 12 realisiert wird unter Ausbildung eines einstückigen bzw. monolithischen Kühlelements 1 mit mindestens einem Kühlkanal.

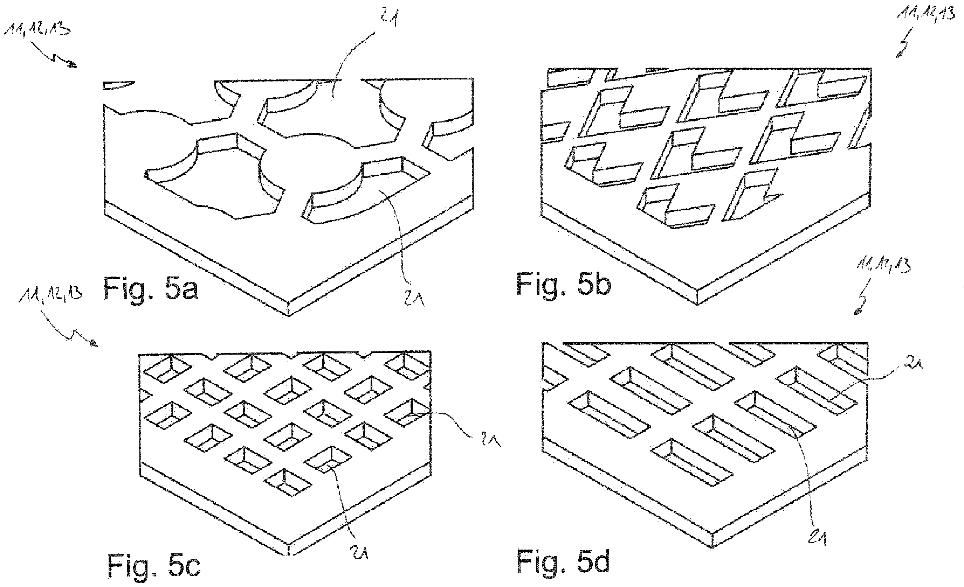

In den **Figuren 5a bis 5d** sind verschiedene Ausgestaltungsformen der mindestens einen ersten Metallschicht 11, der mindestens einen zweiten Metallschicht 12 und/oder der mindestens einen dritten Metallschicht 13 gemäß einer dritten, vierten, fünften und sechsten Ausführungsform der vorliegenden Erfindung dargestellt. Insbesondere handelt es sich um eine mindestens eine erste Metallschicht 11, eine mindestens eine zweite Metallschicht 12 und/oder eine mindestens eine dritte Metallschicht 13, aus denen durch Stapeln und anschließendes Verbinden Kühlelemente 1 geformt werden, die zur Kühlung von Leistungselektronik vorgesehen sind. Dabei werden die mindestens eine erste Metallschicht 11 und/oder die mindestens eine zweite Metallschicht 12, insbesondere ihre Ausnehmungen 21, 22, versetzt zueinander bzw. lateral zueinander verschoben oder zueinander um eine senkrecht zur Haupterstreckungsebene HSE verlaufenden Achse verdreht und anschließend übereinander gestapelt. Dann werden die gestapelten Schichten miteinander durch das Boden verbunden. Dabei wird bevorzugt das oben beschriebene Verfahren zum Herstellen des Kühlelements verwendet. Dadurch bilden sich in gefertigten Kühlelementen 1 mäanderförmige bzw. schleifenförmige Verläufe, die eine möglichst große Kontaktfläche zwischen dem Metall und dem Kühlfluid bilden. Vorzugsweise ist es vorgesehen, dass die ausgeformten Kühlkanäle einen im Wesentlichen U-förmigen Verlauf aufweisen, wobei durch den U-förmigen Verlauf das Kühlfluid zur zu kühlenden Seite, d. h. zur Bauteilseite oder Anschlussfläche, geführt wird und anschließend wieder weggeführt wird. Mit anderen Worten: im Gegensatz zu den Ausführungsformen aus den Figuren 1 und 3 verläuft das Kühlfluid im Wesentlichen nicht parallel zur zu kühlenden Außenseite des Kühlelements 1, sondern im Wesentlichen bzw. größtenteils (d. h. mit Ausnehme des Umkehrabschnitts im schleifenförmigen Abschnitt des Kühlkanals) senkrecht oder schräg (d. h. geneigt zu einer senkrecht zur Haupterstreckungsebene HSE verlaufenden Richtung) zur zu kühlenden Außenseite des Kühlelements 1. Durch eine Vielzahl an solchen schleifenförmigen Kühlkanälen lässt sich dann eine wirkungsvolle und ggf. lokal gezielt ausgerichtete Kühlung realisieren.

Die Ausnehmungen 21, 22 in der mindestens einen ersten Metallschicht 11, der mindestens einen zweiten Metallschicht 12 und/oder der mindestens einen dritten Metallschicht 13, insbesondere in den Figuren 5a bis 5d, haben dabei eine polygone Form, bei der beispielsweise die Ecken abgerundet sein können. Die in der Figuren 5a dargestellte Form hat eine im Wesentlichen hexagonale Grundform, wobei an jeder zweiten Ecke der Grundform der Ausnehmung 21, 22 eine Auswölbung ausgebildet ist. Im zusammengesetzten Zustand bilden die Auswölbungen der einzelnen übereinander gestapelten Metallschichten einen Pfosten, der sich insbesondere zu mehr als die Hälfe, bevorzugt zu mehr als 2/3 und besonders bevorzugt über mehr als ¾ der senkrecht zur Haupterstreckungsebene HSE bemessenen Dicke des Kühlelements 1 erstreckt. Die in Figur 5b gezeigte Ausnehmung 21, 22 hat eine im Wesentlichen V-förmige Kontur, wobei die Ausnehmungen 21, 22 zweier benachbarten Reihen von Ausnehmungen 21, 22 zueinander seitlich versetzt sind. In der Figur 5c sind rechteckige Ausnehmungen 21, 22 vorgesehen, die sich in einem schachbrettähnlichen Muster über die mindestens eine erste Metallschicht 11, die mindestens eine zweite Metallschicht 12 und/oder die mindestens eine dritte Metallschicht 13 erstrecken.

In der Figur 5d sind die rechteckförmigen Ausnehmungen unterschiedlich orientiert, insbesondere derart, dass ihre Längsrichtung zueinander senkrecht stehen. Mit anderen Worten, die rechteckförmigen Ausnehmungen sind zueinander um 90 ° gedreht.

### Bezugszeichenliste:

- 1: Kühlelement
- 7: stegartiges Element
- 11: erste Metallschicht
- 12: zweite Metallschicht
- 13: dritte Metallschicht
- 14: untere Deckschicht
- 15: obere Deckschicht,
- 17: Dichtelementträgerschicht
- 21: erster Teil der Ausnehmung
- 22: zweiter Teil der Ausnehmung
- 24: weitere Ausnehmung
- 25: Finnenstruktur
- 30: Anschlussfläche
- 101: Oxidieren
- 102: Strukturieren
- 103: Verbinden
- A1: Abstand
- S: Stapelrichtung
- M: Mittelachse
- HSE: Haupterstreckungsebene

## Patentansprüche

1. Verfahren zur Herstellung eines Kühlelements (1), insbesondere eines Mikrokühlelements, umfassend:
- Bereitstellen mindestens einer ersten Metallschicht (11) und mindestens einer zweiten Metallschicht (12),
- Oxidieren (101) der mindestens einen ersten Metallschicht (11) und/oder der mindestens einen zweiten Metallschicht (12),
- Strukturieren (102) der mindestens einen ersten Metallschicht (11) und/oder der mindestens einen zweiten Metallschicht (12) zur Ausbildung mindestens einer Ausnehmung (21, 22),
- Verbinden (103) der mindestens einen ersten Metallschicht (11) und der mindestens einen zweiten Metallschicht (12) zur Ausbildung des Kühlelements (1), insbesondere durch Bonden, wobei in einem zusammengefügten Zustand durch die Ausnehmung (21, 22) in der mindestens einen ersten Metallschicht (11) und/oder der mindestens einen zweiten Metallschicht (12) zumindest ein Teilabschnitt eines Kühlkanals im Kühlelement (1) gebildet wird, und wobei vor dem Verbinden (103) eine Innenseite der Ausnehmung (21, 22) zumindest abschnittsweise, vorzugsweise vollständig, befreit von einer oxidierten Oberfläche bereitgestellt wird, wobei zum Strukturieren (102) die mindestens eine erste Metallschicht (11) und/oder die mindestens eine zweite Metallschicht (12) erodiert wird.

2. Verfahren gemäß Anspruch 1, wobei das Oxidieren (101) zeitlich vor dem Strukturieren (102) durchgeführt wird.

3. Verfahren gemäß einem der vorhergehenden Ansprüche, wobei zum Strukturieren (102) die mindestens eine erste Metallschicht (11) und/oder die mindestens eine zweite Metallschicht (12) geätzt, gelasert und/oder laserunterstützt wird.

4. Verfahren gemäß einem der vorhergehenden Ansprüche, wobei vor dem Verbinden (103) ein an die Ausnehmung (21, 22) angrenzender Bereich einer Oberseite und/oder einer Unterseite der mindestens einen ersten Metallschicht (11) und/oder der mindestens einen zweiten Metallschicht (12) befreit von einer oxidierten Oberfläche bereitgestellt wird.

5. Verfahren gemäß einem der vorhergehenden Ansprüche, wobei zusätzlich zu der Aussparung (21, 22) in der mindestens einen ersten Metallschicht (21) und/oder der mindestens einen zweiten Metallschicht (22) ein Bereich reduzierter Dicke realisiert wird.

6. Verfahren gemäß einem der vorhergehenden Ansprüche, wobei das Oxidieren (101) thermisch und/oder nasschemisch durchgeführt wird.

7. Verfahren gemäß einem der vorhergehenden Ansprüche, wobei das gefertigte Kühlelement (1) eine obere Deckschicht (15) und/oder eine untere Deckschicht (14) aufweist, wobei in Stapelrichtung (S) gesehen unter der oberen Deckschicht (15) und/oder über der unteren Deckschicht (14) die mindestens eine erste Metallschicht (11) und/oder die mindestens eine zweite Metallschicht (12) und/oder eine mindestens eine dritte Metallschicht (13) angeordnet wird, wobei die obere Deckschicht (15) und/oder die untere Deckschicht (14) einen Anschlussbereich (30) zur Anbindung eines zu kühlenden Bauteils, insbesondere einer Laserdiode, aufweist.

8. Verfahren gemäß einem der vorhergehenden Ansprüche, wobei die Ausnehmung (21, 22) in einer parallel zu einer Haupterstreckungsebene (HSE) verlaufenden Richtung eine Ausdehnung, eine Breite, bis zu 0,8 mm, bevorzugt bis zu 0,5 mm und besonders bevorzugt bis zu 0,4 mm aufweist.

9. Verfahren gemäß einem der vorhergehenden Ansprüche, wobei ein Bonden, insbesondere ein Erhitzen, beim Verbinden (103) der mindestens einen ersten Metallschicht (11) mit der mindestens einen zweiten Metallschicht (12) bei einer Temperatur zwischen 850 °C und 1080 °C durchgeführt wird.

10. Kühlelement (1) hergestellt mit einem Verfahren gemäß einem der vorhergehenden Ansprüche.
